(19) Europäisches Patentamt
European Patent Office
Office européen des brevets

(11) **EP 3 632 844 A1**

(12) **DEMANDE DE BREVET EUROPEEN**

(43) Date de publication:
08.04.2020 Bulletin 2020/15

(51) Int Cl.:
*C01B 32/158* (2017.01)   *C01B 32/16* (2017.01)

(21) Numéro de dépôt: **19200155.0**

(22) Date de dépôt: **27.09.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **28.09.2018 FR 1858983**

(71) Demandeurs:
• **Commissariat à l'Energie Atomique et aux Energies Alternatives 75015 Paris (FR)**

• **Centre National de la Recherche Scientifique 75016 Paris (FR)**
• **Université Claude Bernard Lyon 1 69622 Villeurbanne, Cedex (FR)**

(72) Inventeurs:
• **RAMOS, Raphael 38170 SEYSSINET- PARISET (FR)**
• **DAVID, Lorie 33480 Castelnau de médoc (FR)**
• **DIJON, Jean 38800 CHAMPAGNIER (FR)**

(74) Mandataire: **Nony 11 rue Saint-Georges 75009 Paris (FR)**

(54) **PROCEDE DE MESURE DE LA HAUTEUR D'UN TAPIS DE NANOTUBES DE CARBONE**

(57)     L'invention concerne un procédé de mesure de la hauteur (H) d'un tapis de nanotubes de carbone, comportant :

a) la fourniture d'un substrat (5) présentant une surface de croissance (20) contenant au moins une zone de mesure (60) comportant une zone de croissance (45) et une zone stérile,
la zone de croissance étant définie par une portion du substrat contenant un catalyseur de croissance des nanotubes, et

b) la croissance catalytique par CVD du tapis (170) de nanotubes sur la zone de croissance,
et au moins au cours de l'étape b) :
- l'irradiation de la zone de mesure avec un faisceau lumineux incident (140) ;
- la mesure en différents instants de l'intensité (I) du faisceau réfléchi (155) par la zone de mesure ;
- la détermination de la hauteur du tapis de nanotubes à partir des intensités du faisceau réfléchi mesurées aux différents instants (t).

Fig. 4

## Description

La présente invention concerne un procédé de mesure de la hauteur d'un tapis de nanotubes en croissance.

La synthèse de tapis de nanotubes de carbone, est opérée industriellement par dépôt chimique en phase vapeur (dénommé « CVD » pour l'acronyme anglais de « *Chemical Vapor Deposition* »), sur un support recouvert d'un catalyseur de la croissance des nanotubes. Un tel procédé est particulièrement sensible aux nombreux paramètres de pilotage d'un réacteur de dépôt par CVD ainsi qu'aux conditions environnementales (température et humidité par exemple). Il est en particulier difficile à contrôler pour obtenir de manière reproductible une hauteur souhaitée du tapis de nanotubes, comme cela est par exemple décrit dans l'article C. Ryan Oliver et al., « Statistical analysis of variation in laboratory growth of carbon nanotubes forests and recommendations for improved consistency », ACS NANO, vol. 7, No. 4, pp 3565-3580, 2013.

Or, pour certaines applications, par exemple lorsque le tapis de nanotubes est destiné à former un organe d'interposition pour la gestion thermique d'un composant électronique, ou à former un fil ou une nappe, il est nécessaire de produire un tapis avec une hauteur contrôlée.

Des méthodes sont connues pour déterminer l'évolution de la hauteur d'un tapis de nanotubes en croissance.

Par exemple, l'article A. A. Puretzky et al., « real-time imaging of vertically aligned carbon nanotube array growth kinetics », Nanotechnology, 19 (2008), p. 05560 décrit une méthode de suivi de la hauteur au moyen d'images prises à l'aide d'un téléobjectif. Une succession d'images de la section transversale d'un tapis de nanotubes en croissance située sur le bord d'un substrat est analysée. Toutefois, outre sa résolution limitée, une telle méthode est réservée au suivi de la croissance sur des substrats d'une taille inférieure aux substrats industriels. Il est en effet nécessaire que la croissance en périphérie du substrat soit sensiblement homogène à celle au centre du substrat. Une telle méthode ne peut donc pas être mise en œuvre industriellement.

L'article E.R. Meshot et A.J. Hart, « Abrupt self-termination of vertically aligned carbon nanotube growth », Applied Physics Letters 92, 113107 (2008), propose de détecter la position d'une portion de la face supérieure d'un tapis de nanotubes en croissance au moyen d'un faisceau laser. Toutefois, en raison du caractère optiquement absorbant d'un tapis de nanotubes, cette technique requiert le dépôt d'un élément réfléchissant sur la portion, ce qui perturbe localement les échanges thermiques et gazeux, si bien que la hauteur du tapis de nanotubes sous la portion recouverte par le revêtement peut être sensiblement différente des autres portions du tapis.

L'article Y. Hayashi et al., « Analysis of early stages of vertically aligned carbon nanotube growth by plasma-enhanced chemical vapor deposition », Japanese Journal of Applied Physics, vol. 44, No. 4A, 2005 pp. 1549-1553 et l'article D.B. Geoghegan et al., « In situ growth rate measurements and length control during chemical vapor deposition of vertically aligned multiwall carbon nanotubes », Applied Physics Letters, Vol. 83, No. 9, 2003, pp 1851-1853 décrivent le suivi de la hauteur de tapis de nanotubes en croissance par ellipsométrie et par réflectométrie respectivement. Les auteurs mettent à profit ces techniques pour déterminer la hauteur d'un tapis de nanotubes en quantifiant la modification de la polarisation et de l'intensité d'un faisceau lumineux respectivement, après réflexion par un tapis de nanotubes. Néanmoins, de telles techniques sont pénalisées par l'absorption optique du tapis de nanotubes. Elles sont inadaptées à la mesure de la hauteur de tapis présentant une hauteur supérieure à 10 $\mu$m. Or, les tapis de nanotubes produits industriellement présentent des hauteurs qui peuvent être supérieures à 100 $\mu$m.

Il existe donc un besoin pour une méthode qui permette de mesurer, de manière fiable et reproductible, la hauteur d'un tapis de nanotubes dans des conditions industrielles de croissance.

L'invention répond à ce besoin et propose un procédé de mesure de la hauteur d'un tapis de nanotubes de carbone, le procédé comportant les étapes de :

a) fourniture d'un substrat présentant au moins une surface de croissance, la surface de croissance contenant au moins une zone de mesure comportant une zone de croissance et une zone stérile à la croissance des nanotubes, dite zone « vierge », la zone de croissance étant définie par une portion du substrat contenant un catalyseur de la croissance des nanotubes, et
b) croissance catalytique, au sein d'un réacteur de dépôt chimique en phase vapeur, du tapis de nanotubes sur la zone de croissance,

le procédé comportant au moins au cours de l'étape b) :

- l'irradiation de la zone de mesure au moyen d'un faisceau lumineux incident;
- la mesure en différents instants de l'intensité du faisceau réfléchi par la zone de mesure ;
- la détermination de la hauteur du tapis de nanotubes à partir des intensités du faisceau réfléchi mesurées aux différents instants (t).

Une mesure simple de la hauteur du tapis de nanotubes de carbone peut être effectuée au moyen du procédé. En particulier, la mesure de la hauteur du tapis sur la zone de mesure est représentative de la hauteur du tapis pouvant croître en des zones différentes et notamment éloignées de la zone de mesure. Par ailleurs, la croissance des nanotubes sur des zones différentes de la zone de mesure n'est pas affectée par la présence de la zone de mesure. Notamment, le procédé peut être mis en œuvre sans qu'un élément soit déposé sur le tapis de nanotubes. On limite ainsi l'introduction d'artefacts expérimentaux dans la détermination de la hauteur.

Par ailleurs, le procédé selon l'invention requiert peu, voire pas de modifications du réacteur de dépôt CVD.

En outre, la zone de mesure peut être disposée sur une partie du substrat qui est destinée à être sacrifiée, par exemple découpée, une fois que la croissance du tapis de nanotubes est finie. Ainsi, le procédé ne réduit pas le rendement de production de tapis de nanotubes.

Par ailleurs, le procédé permet la mesure de hauteurs de tapis de nanotubes produits industriellement. En particulier, comme cela sera apparent par la suite, en fonction de la forme et des dimensions de la zone de croissance et de la zone vierge, ainsi que de l'angle d'incidence du faisceau incident sur le substrat, des hauteurs supérieures à 150 $\mu$m, voire même supérieures à 500 $\mu$m peuvent être mesurées, mieux supérieures à 1 mm.

De préférence, la zone vierge est définie par une autre portion du substrat qui absorbe moins et/ou réfléchit plus le faisceau lumineux incident que le tapis de nanotubes. On tire ainsi profit du caractère optiquement absorbant des nanotubes qui occultent progressivement au cours de la croissance du tapis, à la manière d'un diaphragme, l'intensité du faisceau réfléchi.

L'homme du métier sait aisément déterminer de telles propriétés. Le coefficient d'absorption d'un tapis de nanotubes de carbone, mesuré par spectroscopie optique, peut être compris entre 0,95 et 0,9999 dans la gamme spectrale de longueurs d'ondes comprises entre 200 nm et 20 $\mu$m, par exemple supérieur à 0,97 à une longueur d'onde égale à 635 nm. Par exemple, le substrat peut comporter une zone vierge définie par de l'alumine sur du silicium qui présente un coefficient de réflexion supérieur à 15% à une longueur d'onde égale à 635 nm. Le coefficient de réflexion peut notamment être mesuré par réflectométrie.

Un « tapis de nanotubes » désigne un assemblage organisé de nanotubes de carbone, dans lequel les nanotubes sont sensiblement parallèles les uns aux autres, orientés chacun sensiblement perpendiculairement à la surface de croissance sur laquelle ils ont crû, et dont la hauteur est proche de la longueur unitaire des nanotubes.

Par « croissance catalytique » du tapis de nanotubes, on entend que la croissance des nanotubes du tapis est activée au moyen du catalyseur.

A l'étape a), on dispose d'un substrat présentant une surface de croissance pour la croissance catalytique des nanotubes de carbone.

L'homme du métier sait de manière routinière choisir un tel catalyseur.

Le catalyseur peut notamment comporter un élément choisi parmi le fer, le cobalt, le nickel, le palladium et leurs mélanges.

De préférence, le substrat comporte un support et un revêtement recouvrant partiellement le support. Un « support » présente une rigidité telle qu'il ne rompt pas sous l'effet de son propre poids.

Un tel revêtement peut être déposé sur le support par différentes méthodes connues de l'homme du métier. Par exemple, il peut être déposé par évaporation e-beam.

De préférence, le revêtement contient le catalyseur. Le revêtement peut être multicouche. Par exemple, il est constitué d'une couche d'aluminium d'épaisseur pouvant être comprise entre 1 nm et 100 nm et d'une couche formée du catalyseur. Il peut aussi être constitué de plusieurs couches métalliques, par exemple en titane et en aluminium, et d'une couche formée du catalyseur. Le brevet WO-A-2014/191915 décrit un exemple d'un tel revêtement multicouche.

Le support peut être constitué par un bloc ou une plaque métallique, éventuellement recouvert d'un ou plusieurs oxydes, par exemple de l'alumine, ou d'un matériau carboné, par exemple du graphène ou du carbone amorphe, ou de métaux, par exemple de l'aluminium, du TaN ou du TiN. Le support peut être multicouche. Par exemple, il est constitué d'une plaque de silicium ayant notamment une épaisseur supérieure à 0,3 mm, recouverte d'une couche d'alumine d'épaisseur pouvant être comprise entre 1 nm et 100 nm.

Le revêtement peut être formé sur le support, de manière à définir la zone de croissance et le cas échéant la zone vierge, par une méthode choisie par l'homme de l'art. Par exemple, le revêtement peut être déposé à travers un masque mécanique, au moyen d'un masquage résine, ou être obtenu par ablation après dépôt d'un revêtement ou de la couche catalytique.

Le revêtement présente une première face en regard du support et une deuxième face opposée à la première face. De préférence, la zone de croissance est définie par la deuxième face.

De préférence, la zone vierge est au moins partiellement définie par la portion de la face du support, dite « portion libre », complémentaire à la portion de la face du support recouverte par le revêtement. La zone vierge est de préférence définie par une portion du support, par exemple la portion libre, en un matériau inerte vis-à-vis de la croissance des nanotubes. L'homme du métier sait choisir simplement et de manière routine un tel matériau inerte.

La zone de croissance et la zone vierge sont de préférence contigües. De préférence la zone vierge est séparée par deux zones de croissance consécutives.

De préférence, la zone de croissance et la zone vierge définissent un motif de mesure, la zone de mesure étant définie par la répétition régulière, de préférence périodique, selon au moins une direction du motif de mesure. La zone de mesure peut être définie par la répétition régulière, de préférence périodique, selon deux directions orthogonales ou non.

Le motif peut être répété au moins 1 fois, de préférence au moins 3 fois, voire au moins 10 fois selon au moins une direction de sorte que la zone de mesure soit d'étendue plus grande que la surface projetée du faisceau lumineux incident sur le substrat.

Par exemple, le motif de mesure peut être répété selon deux directions orthogonales de telle sorte que les zones de croissance et zone vierge soient disposées dans la zone de mesure à la manière d'un damier.

De préférence, la zone de croissance et la zone vierge présentent chacune une forme de bande, de préférence rectiligne. La zone de croissance et la zone vierge peuvent s'étendre selon des directions parallèles. Elles s'étendent de préférence selon une direction commune. En particulier, elles peuvent partager un bord long commun et définir le motif de mesure, qui de préférence est répété périodiquement le long d'une direction perpendiculaire à la direction d'extension commune.

De préférence, la zone de croissance en bande présente une largeur comprise entre 30 $\mu$m et 500 $\mu$m, par exemple égale à 200 $\mu$m et/ou la zone vierge en bande présente une largeur comprise entre 30 et 10000 $\mu$m, par exemple égale à 500 $\mu$m.

La zone de mesure peut présenter un contour de forme variée, par exemple rectangulaire, circulaire, carré ou losange.

Elle peut être disposée dans la partie centrale de la surface de croissance ou auprès du bord du substrat.

De préférence, l'aire de la zone de mesure est supérieure à la taille du faisceau lumineux sur le support.

Par ailleurs, le substrat peut comporter une autre zone de croissance, définie par une autre portion du substrat comportant le catalyseur, et disposée à distance de la zone de mesure. L'autre zone de croissance encadre par exemple la zone de mesure. L'autre zone de croissance est ainsi destinée à la production industrielle d'un tapis de nanotubes ou de composants intégrants des tapis de nanotubes.

La zone de mesure peut être disposée sur une partie du substrat destinée à être sacrifiée en fin d'étape de croissance du tapis de nanotubes. Par exemple, en fin de d'étape de croissance des nanotubes, l'autre zone de croissance peut être recouverte par un autre tapis de nanotubes, et le substrat peut être découpé selon un tracé de découpe incluant la zone de mesure.

A l'étape b), on fait croître des nanotubes sur la zone de croissance.

La croissance du tapis de nanotubes est opérée dans l'enceinte d'un réacteur de croissance catalytique par dépôt chimique en phase vapeur.

La croissance par CVD des nanotubes peut être menée de manière conventionnelle dans le domaine considéré. L'homme du métier sait définir de manière routinière les paramètres, notamment la température, la pression et le débit des gaz précurseurs du matériau constitutif des nanotubes, permettant de garantir la croissance des nanotubes sur la surface de croissance d'un substrat disposé dans l'enceinte du réacteur CVD.

Par exemple, pour faire croître un tapis de nanotubes de carbone, l'homme du métier peut choisir un précurseur carboné étant par exemple l'acétylène.

Le substrat peut être porté dans l'enceinte à une température comprise entre 350 °C et 900 °C, en particulier comprise entre 500 °C et 700 °C.

La pression de l'enceinte peut être comprise entre comprise entre 0,1 mbar et 1000 mbar, en particulier entre 0,1 et 10 mbar.

Par ailleurs, au moins au cours de la croissance du tapis de nanotubes à l'étape b), on détermine la hauteur du tapis de nanotubes.

La détermination de la hauteur du tapis de nanotubes requiert au préalable l'irradiation de la zone de mesure au moyen d'un faisceau lumineux incident, puis la mesure de l'intensité du faisceau réfléchi par la zone de mesure.

Lorsqu'un précurseur des nanotubes entre en contact de la zone de croissance, une réaction catalysée par le catalyseur s'opère entre les précurseurs des nanotubes. Les nanotubes croissent alors selon une direction sensiblement perpendiculaire à la surface de croissance du substrat.

Au contraire, au contact de la zone vierge, sensiblement aucune réaction ne s'opère du fait d'une absence du catalyseur. Sensiblement aucun nanotube ne croît à partir de la zone vierge. Ainsi, au cours de la croissance, la zone vierge reste sensiblement exempte de nanotubes. Par ailleurs, les propriétés optiques du matériau de la partie du substrat qui définit la zone vierge restent de préférence constantes au cours de la croissance des nanotubes.

Le faisceau lumineux incident peut être monochromatique ou polychromatique. En particulier, le faisceau lumineux incident peut être un faisceau laser parallèle, de préférence ayant une longueur d'onde comprise entre 200 nm et 20 $\mu$m, voire entre 350 nm et 700 nm, par exemple égale à 635 nm. En particulier, le faisceau lumineux incident peut présenter un diamètre compris entre 1 $\mu$m et 1 cm.

En variante, le faisceau lumineux incident peut être un faisceau de lumière visible, notamment polychromatique et présentant un spectre de longueurs d'ondes comprises entre 200 nm et 800 nm, voire comprises entre 380 nm et 780 nm.

Le faisceau lumineux incident peut être émis par une source lumineuse, par exemple une diode laser, reliée à une source d'alimentation électrique. L'intensité du faisceau lumineux incident peut ainsi aisément déterminable, si nécessaire.

La zone de mesure peut être irradiée pendant au moins 50 % de la durée de l'étape b) de croissance ou tout au long de la croissance du tapis de nanotubes.

La source lumineuse est de préférence disposée à l'extérieur de l'enceinte du réacteur catalytique. La ou les parois séparant l'enceinte de la source lumineuse peuvent comporter une ouverture et/ou une portion transparente au faisceau lumineux incident, par exemple un hublot en quartz, pour la transmission du faisceau lumineux incident de la source vers le substrat. La source lumineuse est ainsi protégée de l'atmosphère et des effets de la température pouvant régner dans l'enceinte au cours du dépôt.

La hauteur maximale d'un tapis de nanotubes pouvant être déterminée peut être liée à la valeur de l'angle d'incidence du faisceau lumineux incident. L'angle d'incidence est défini entre la direction du faisceau lumineux et la surface de croissance.

L'angle d'incidence du faisceau lumineux incident peut être supérieur à 0 °, de préférence supérieur à 10 ° et/ou inférieur à 90 °, par exemple inférieur à 80 °, de préférence compris entre 30 ° et 60 °. Ainsi, au fur et à mesure de sa croissance, le tapis de nanotubes définit un écran qui empêche le rayonnement incident d'atteindre une partie de la zone vierge, dite « partie ombrée ».

Par ailleurs, dans la variante où la zone de croissance et la zone vierge se présentent chacune sous la forme d'une bande, de préférence les zone de croissance et zone vierge sont de préférence perpendiculaires au plan normal au substrat comportant la direction de propagation du faisceau lumineux incident. Une telle disposition de la zone de mesure par rapport au faisceau lumineux incident facilite la détermination de la hauteur du tapis de nanotubes.

De préférence, le faisceau lumineux incident irradie au moins 50 % et de préférence moins de 90 % de l'aire de la zone de mesure.

Le faisceau incident est réfléchi par la zone de mesure.

L'intensité du faisceau réfléchi peut être mesurée au moyen d'un photodétecteur. Le photodétecteur est de préférence disposé hors de l'enceinte, afin de le protéger des gaz réactifs et de la température de l'enceinte. La ou les parois séparant l'enceinte du photodétecteur peuvent comporter une ouverture et/ou une autre portion transparente au faisceau réfléchi pour transmettre le faisceau réfléchi de la zone de mesure au photodétecteur.

Le photodétecteur comporte par exemple une photodiode en silicium. Il peut comporter un filtre passebande centré sur la ou les longueurs d'onde du faisceau incident, qui peut être monté sur la photodiode, pour réduire l'influence de la lumière environnante. Par ailleurs, un miroir chaud peut être monté sur la photodiode, pour limiter l'influence du rayonnement infrarouge pouvant être émis par l'enceinte et les objets qui y sont contenus, sur la mesure de l'intensité du rayonnement réfléchi.

La mesure de l'intensité du faisceau réfléchi est de préférence effectuée en continu tout au long de la croissance du tapis de nanotubes.

Par exemple, l'intensité du faisceau lumineux peut être mesurée avec une fréquence de mesure comprise entre 0,1 Hz et 1 MHz.

L'intensité du faisceau réfléchi peut décroître avec une augmentation de la hauteur du tapis de nanotubes. Elle peut notamment décroître plus rapidement dans une première phase de croissance que dans une deuxième phase successive à la première phase.

En particulier, l'intensité du faisceau réfléchi peut décroître par morceaux en fonction de la hauteur du tapis de nanotubes. De préférence, elle décroît par morceaux selon des première et deuxième portions. La première portion présente des oscillations atténuées, qui résultent d'interférences optiques que l'homme de l'art sait reconnaître et exploiter, par exemple au moyen d'une technique de réflectométrie classique. La deuxième portion décroît linéairement avec la hauteur du tapis de nanotubes.

En particulier, l'intensité du faisceau réfléchi peut décroître en fonction de la hauteur du tapis de nanotubes, jusqu'à atteindre une intensité seuil minimale. De préférence, la hauteur maximale mesurable du tapis de nanotubes est déterminée au premier instant de mesure où l'intensité du faisceau réfléchi atteint l'intensité seuil minimale. L'intensité seuil minimale peut être nulle ou résulter des effets de la lumière parasite atteignant le photodétecteur.

La hauteur du tapis de nanotubes est déterminée à partir des intensités du faisceau réfléchi mesurées aux différents instants. En particulier, l'intensité du faisceau réfléchi est mesurée en au moins deux instants différents de la croissance.

De préférence, pendant au moins une partie de la croissance du tapis de nanotubes, la hauteur du tapis de nanotubes croît, de préférence de façon continûment monotone, en fonction de la décroissance de l'intensité du faisceau réfléchi. De préférence, pendant au moins une partie de la croissance du tapis de nanotubes, la hauteur du tapis de nanotubes croît de préférence de façon continûment monotone et linéairement en fonction de la décroissance de l'intensité du faisceau réfléchi.

L'invention pourra être mieux comprise à la lecture de la description détaillée qui va suivre et du dessin annexé dans lequel :

- les figures 1a et 1b illustrent un substrat, vu en perspective et en coupe respectivement, pour la mise en œuvre du procédé selon l'invention,
- la figure 2 illustre un dispositif pour la mise en œuvre du procédé selon l'invention, 1
- la figure 3 est un graphique représentant schématiquement l'évolution de l'intensité du faisceau réfléchi en fonction de la hauteur du tapis de nanotubes,
- la figure 4 est une photographie prise en microscopie à balayage d'une section transverse du substrat sur lequel a crû un tapis de nanotubes selon un exemple de mise en œuvre du procédé,
- la figure 5 est un graphique représentant l'évolution au cours d'un exemple de mise en œuvre du procédé, l'évolution de l'intensité du faisceau réfléchi, et
- la figure 6 est un graphique représentant l'évolution de la hauteur du tapis de nanotubes en fonction de la durée de croissance.

Les éléments représentés sur le dessin le sont en échelle libre.

La figure la-b illustre un exemple de substrat 5.

Le substrat comporte un support 10 et un revêtement 15 recouvrant le support. Le substrat présente une surface de croissance 20 destiné à recevoir les nanotubes 25 en croissance.

Le support comporte une plaque 30 de silicium, de longueur, largeur et épaisseur respectivement égales à 30 mm, 30 mm et 0,5 mm. La plaque présente une face totalement recouverte d'une couche mince 35 d'alumine, déposée par dépôt de couche atomique, (ALD), d'une épaisseur de 10 nm. Le revêtement est au contact de la couche d'alumine. Il est déposé par évaporation e-beam.

Le revêtement est une couche mince de fer, d'une épaisseur de 1 nm. Le fer est un catalyseur de la croissance de nanotubes de carbone.

Le revêtement se présente sous la forme de bandes $40_{1-4}$, chacune d'une largeur L égale à 200 $\mu$m, disposées parallèlement les unes aux autres et espacées périodiquement selon une direction X perpendiculaire aux directions $Y_{1-4}$ d'extensions des bandes, la distance de séparation S entre les bandes du revêtement étant égale à 500 $\mu$m.

Le revêtement comporte une première face 46 disposée en regard du support et une deuxième face 47 opposée à la première face, la deuxième face définissant une zone de croissance 45 pour le tapis de nanotubes. Une portion (48) de la face du support disposée entre deux bandes du revêtement définit quant à elle une zone vierge 50 sur la face du substrat sur laquelle le revêtement est disposé. La zone vierge est exempte de catalyseur et ainsi stérile à la croissance des nanotubes.

La zone de croissance et la zone vierge définissent ainsi un motif de mesure 55 qui est répété périodiquement selon la direction X, formant ainsi une zone de mesure 60. La zone de mesure présente un contour rectangulaire de longueur $L_m$ et largeur $l_m$ égales à 15 mm et 10 mm.

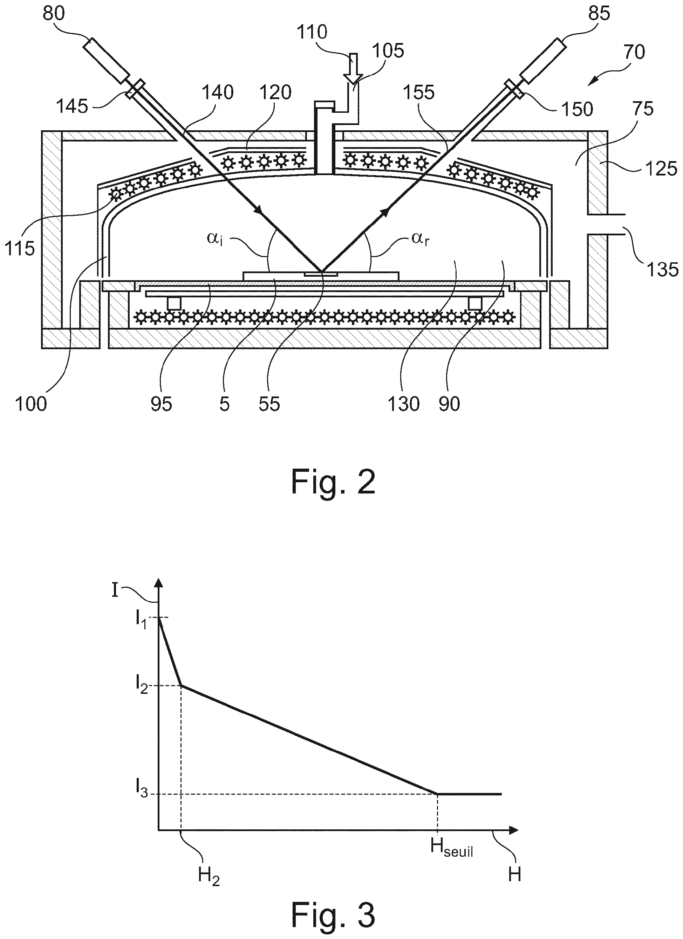

La figure 2 illustre un exemple de dispositif 70 pour mettre en œuvre le procédé selon l'invention.

Le dispositif comporte un réacteur 75 de dépôt chimique en phase vapeur, une diode 80 laser et un photodétecteur 85.

Le réacteur comporte une enceinte 90 au sein de laquelle s'opère la croissance catalysée du tapis de nanotubes. Le réacteur de dépôt CVD est par exemple un réacteur « plaque à plaque » commercialisé par la société Plassys.

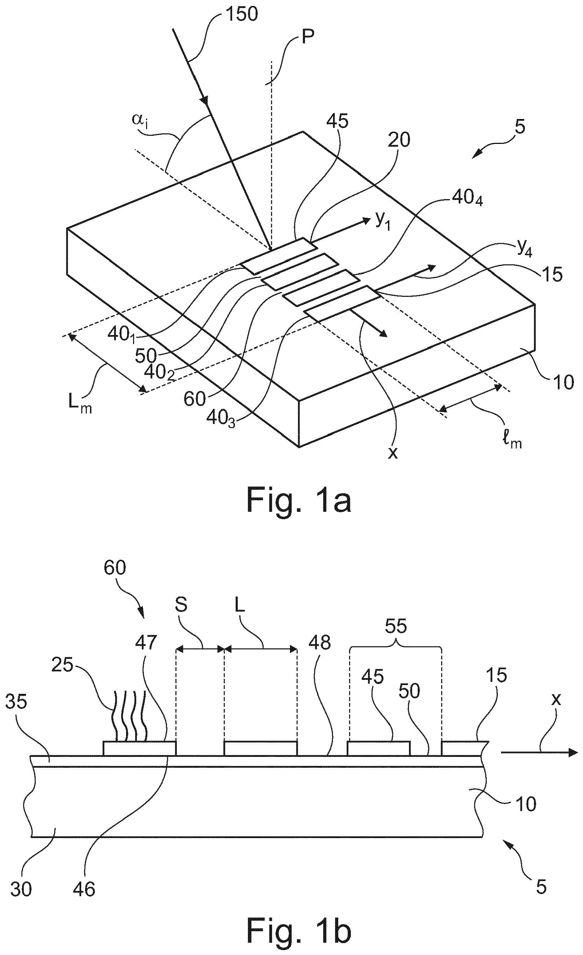

Le réacteur comporte un porte-substrat 95 chauffant en graphite logé dans l'enceinte, et sur lequel est disposé le substrat 5 illustré sur la figure 1.

Une cloche 100 en quartz surmonte le porte substrat et le substrat. Elle est dotée d'une ouverture 105 pour l'entrée de gaz précurseurs du matériau des nanotubes, illustrée par la flèche 110. Dans l'exemple de la figure 2, le gaz précurseur comporte de l'acétylène, de l'hydrogène et de l'hélium. L'acétylène apporte le carbone nécessaire à la croissance d'un tapis de nanotubes de carbone.

Des éléments chauffants 115 et des réflecteurs thermiques 120 sont disposés entre la paroi 125 de l'enceinte et la cloche en quartz pour chauffer l'espace de réaction 130 défini sous la cloche dans lequel se produit la réaction de catalyse.

L'enceinte comporte en outre une ouverture de sortie 135 pour l'évacuation des produits de réaction gazeux.

Dans l'exemple de la figure 2, la croissance des nanotubes est opérée en portant le porte substrat à une température de 600°C. La pression dans l'enceinte est de 0,3 Torr.

La diode laser est disposée à l'extérieur de l'enceinte. Elle émet un faisceau lumineux incident 140 sous forme d'un faisceau laser d'une longueur d'onde égale à 636 nm. Elle est orientée de sorte que le faisceau laser soit dirigé pour irradier la zone de mesure 55. A cette fin, la paroi de l'enceinte du réacteur comporte en outre un hublot 145 en quartz disposé sur le chemin optique du faisceau laser incident.

L'angle d'incidence $\alpha_i$ du laser sur la zone de mesure est de 42 °, défini entre la direction de propagation du laser et une normale $\vec{n}$ au substrat. Comme cela est représenté sur la figure 1, les zones de croissance et les zones vierges, qui s'étendent chacune en bande selon les directions $Y_{1-4}$, parallèles les unes autres, sont disposées perpendiculairement au plan P comportant la direction 150 de propagation du faisceau laser incident.

Le faisceau laser incident est réfléchi par la zone de mesure, tant que le tapis de nanotubes n'a pas atteint une hauteur telle qu'il empêche le faisceau laser incident d'atteindre les zones vierges.

L'angle de réflexion $\alpha_r$ du faisceau laser réfléchi est égal à l'angle d'incidence.

Le photodétecteur est disposé hors de l'enceinte le long du trajet optique du faisceau réfléchi 155. La paroi de l'enceinte comporte en outre une fenêtre 160 en quartz pour isoler le photodétecteur de l'enceinte et transmettre le faisceau réfléchi.

Le graphique de la figure 3 représente schématiquement l'évolution de l'intensité I du faisceau réfléchi en fonction de la hauteur H du tapis de nanotubes dans le réacteur CVD de la figure 2.

Avant que la croissance des nanotubes ne soit opérée, la zone de mesure réfléchit le faisceau laser incident, en fonction des propriétés de réflexion de la couche mince d'alumine définissant la zone vierge et de la couche mince de fer définissant la zone de croissance. Une intensité $I_1$ est mesurée.

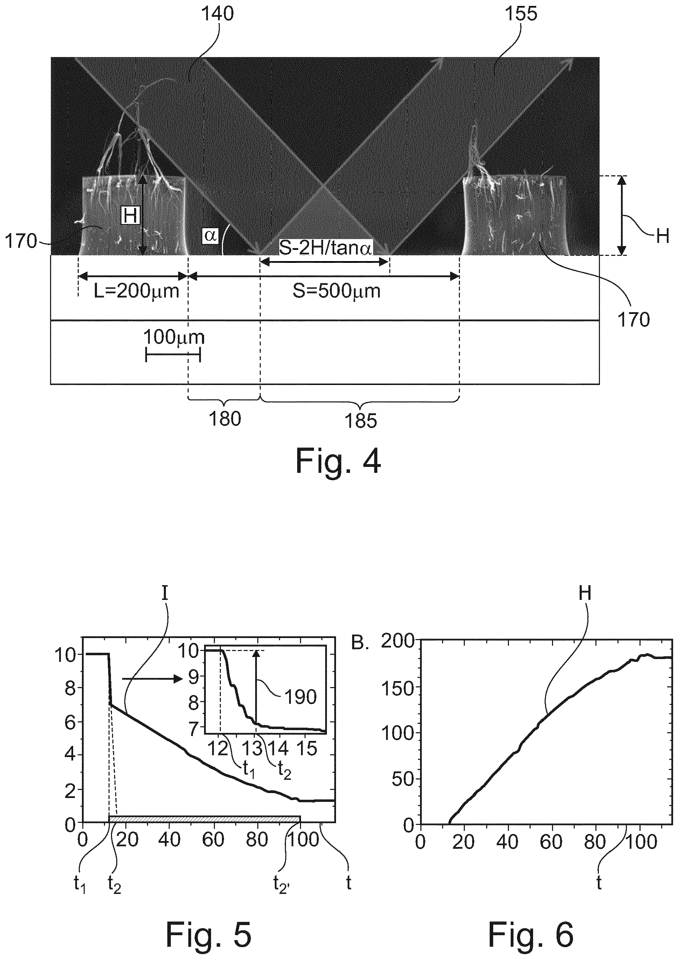

A partir de t=$t_1$, on opère la croissance des nanotubes. Au cours de la croissance, aucun catalyseur n'étant présent sur les zones vierges, aucun nanotube ne croît sur ces dernières. Au contraire, par interaction entre le gaz précurseur comportant l'acétylène et le fer, des nanotubes de carbone croissent sur les zones de croissance. Dans l'exemple illustré, les zones de croissance sont réfléchissantes avant que ne croissent les nanotubes de carbone. Le tapis de nanotubes ne réfléchit plus le faisceau laser incident dès qu'il atteint à l'instant $t_2$ une hauteur $H_2$, qui dans l'exemple illustré est de l'ordre de 4 $\mu$m, comme cela peut être vérifié *a posteriori* au moyen d'une mesure sur une photographie prise par exemple en microscopie électronique à balayage ou d'une mesure de réflectivité sur une portion du substrat exempte de zone « vierge ». L'intensité décroît donc rapidement en fonction de la hauteur H entre le début de la croissance où la hauteur est nulle et la hauteur $H_2$. Tant que la hauteur est inférieure à $H_2$, le tapis de nanotubes de carbone est semi-transparent et on peut observer des interférences optiques comme cela se manifeste sur la courbe illustrée sur la figure 5.

Lorsque la hauteur H augmente, comme cela est illustré sur la figure 4, le tapis 170 de nanotubes absorbe une partie du faisceau laser et, de cette façon, forme une ombre 180 sur la zone vierge. La partie 185 de la zone vierge irradiée par le faisceau laser incident et qui est réfléchi diminue alors linéairement avec l'augmentation de la hauteur. Elle vaut alors S-2H/tan($\alpha$). L'intensité du faisceau réfléchi diminue alors aussi linéairement jusqu'à atteindre une intensité seuil minimale $I_3$, pour laquelle les tapis de nanotube ayant crû sur les zones de croissance forment des écrans ombrant toutes les zones vierges. Sensiblement aucun faisceau n'est alors réfléchi par la zone de mesure. L'intensité seuil minimale $I_3$ correspond donc à la hauteur maximale du tapis de nanotubes pouvant être mesurée. Elle peut être non nulle et correspondre à l'intensité des rayonnements parasites mesurés par le photodétecteur.

Dans l'exemple illustré, l'intensité $I_2$ vérifie l'équation (1) suivante :

$$\frac{I_2 - I_3}{I_1 - I_3} = \frac{S}{S + L} \quad (1)$$

Lorsque l'intensité du faisceau réfléchi est comprise entre $I_2$ et $I_3$, la hauteur du tapis H peut être déterminée, de manière approchée, en résolvant l'équation (2)

$$\frac{I_2 - I_3}{I_1 - I_3} = \frac{S - 2H/\tan(\alpha)}{S + L} \quad (2)$$

L'équation (2) fournit une détermination de la hauteur H avec une précision de mesure de l'ordre de $H_2$/2.

Par exemple dans l'exemple illustré, les intensités $I_1$ et $I_3$ exprimées en tension de sortie mesurée sur la photodiode sont égales à 10 V et 0V.

L'évolution de l'intensité I, exprimée en volts, du faisceau réfléchi en fonction de la durée de croissance t du tapis de nanotubes est illustrée sur la figure 5. La croissance des nanotubes est opérée entre $t_1$ et $t_{2'}$. Comme expliqué ci-dessus l'intensité diminue rapidement entre les instants $t_1$ et $t_2$, instant auquel le tapis atteint la hauteur $H_2$. L'atténuation 190 de l'intensité entre les instants $t_1$ et $t_2$ respecte l'équation (1). Par la suite, l'intensité du faisceau réfléchi décroît plus faiblement au cours de la croissance du tapis de nanotubes jusqu'à l'instant $t_{2'}$.

Au moyen de l'équation 2, la hauteur H du tapis de nanotubes de carbone peut être déterminée avec une précision de $H_2$/2 en fonction de la durée de croissance t, comme illustré sur la figure 6. Une hauteur de tapis atteignant 185 $\pm$ 2 $\mu$m est mesurée dans cet exemple. La hauteur $H_2$ est de 4 $\mu$m pour l'exemple de mise en œuvre du procédé.

Le procédé selon l'invention est donc particulièrement bien adapté à la mesure de hauteur de tapis de nanotubes obtenus au sein de réacteurs industriels.

L'invention n'est pas limitée aux exemples de mise en œuvre décrits ici à des fins illustratives.

Notamment, d'autres motifs de mesure de forme plus complexe peuvent être envisagés. L'homme du métier sait alors adapter aisément les équations (1) et (2) en conséquence.

Par exemple, pour faciliter le positionnement de la zone de mesure par rapport au faisceau incident, la zone de mesure peut être formée d'une pluralité de zones vierges disposées de manière à former un réseau hexagonal, les zones vierges présentant un contour circulaire et étant entourés par une zone de croissance environnante.

## Revendications

1.   Procédé de mesure de la hauteur (H) d'un tapis de nanotubes de carbone, le procédé comportant les étapes de :

   a) fourniture d'un substrat (5) présentant une surface de croissance (20),
   la surface de croissance contenant au moins une zone de mesure (60) comportant une zone de croissance (45) et une zone stérile à la croissance des nanotubes, dite zone « vierge » (50), la zone de croissance étant définie par une portion du substrat contenant un catalyseur de la croissance des nanotubes, et
   b) croissance catalytique, au sein d'un réacteur (75) de dépôt chimique en phase vapeur, du tapis (170) de nanotubes sur la zone de croissance,

   le procédé comportant au moins au cours de l'étape b) :

   - l'irradiation de la zone de mesure au moyen d'un faisceau lumineux incident (140);
   - la mesure en différents instants de l'intensité (I) du faisceau réfléchi (155) par la zone de mesure ;

- la détermination de la hauteur du tapis de nanotubes à partir des intensités du faisceau réfléchi mesurées aux différents instants (t).

**2.** Procédé selon la revendication 1, dans lequel la zone vierge est définie par une autre portion du substrat qui absorbe moins et/ou réfléchit plus le faisceau lumineux incident que le tapis de nanotubes.

**3.** Procédé selon l'une quelconque des revendications 1 et 2, le substrat comportant un support (10) et un revêtement (15) recouvrant partiellement le support, le revêtement contenant le catalyseur.

**4.** Procédé selon la revendication précédente, le revêtement comportant une première face (46) disposée en regard du support et une deuxième face (47) opposée à la première face, la zone de croissance étant définie par la deuxième face.

**5.** Procédé selon l'une quelconque des revendications précédentes, dans lequel la zone vierge est définie par une portion du support en un matériau inerte vis-à-vis de la croissance des nanotubes.

**6.** Procédé selon l'une quelconque des revendications précédentes, la zone vierge étant au moins partiellement définie par la portion (48) de la face du support complémentaire à la portion de la face du support recouverte par le revêtement.

**7.** Procédé selon l'une quelconque des revendications précédentes, dans lequel la zone de croissance et la zone vierge définissent un motif de mesure (55), la zone de mesure étant définie par la répétition régulière, de préférence périodique, selon au moins une direction (X) du motif de mesure.

**8.** Procédé selon l'une quelconque des revendications précédentes, la zone de croissance et la zone vierge présentant chacune une forme de bande, de préférence rectiligne.

**9.** Procédé selon l'une quelconque des revendications précédentes, la zone de croissance présentant une largeur (L) comprise entre 30 $\mu$m et 500 $\mu$m, par exemple égale à 200 $\mu$m et/ou la zone vierge présentant une largeur (S) comprise entre 30 $\mu$m et 10000 $\mu$m, par exemple égale à 500 $\mu$m.

**10.** Procédé selon l'une quelconque des revendications précédentes, dans lequel les zone de croissance et zone vierge sont perpendiculaires au plan comportant la direction de propagation du faisceau lumineux incident.

**11.** Procédé selon l'une quelconque des revendications précédentes, dans lequel le faisceau lumineux incident est un faisceau laser parallèle, de préférence ayant une longueur d'onde comprise entre 200 nm et 20 $\mu$m, voire entre 350 nm et 700 nm, par exemple égale à 635 nm.

**12.** Procédé selon l'une quelconque des revendications précédentes, dans lequel l'angle d'incidence ($\alpha_i$) du faisceau lumineux incident est supérieur à 0 °, de préférence est compris entre 30 ° et 60 °.

**13.** Procédé selon l'une quelconque des revendications précédentes, dans lequel pendant au moins une partie de la croissance du tapis de nanotubes, la hauteur du tapis de nanotubes croît, de préférence de façon continûment monotone, en fonction de la décroissance de l'intensité du faisceau réfléchi.

**14.** Procédé selon la revendication précédente, dans lequel pendant au moins une partie de la croissance du tapis de nanotubes, la hauteur du tapis de nanotubes croît de préférence de façon continûment monotone linéairement en fonction de de la décroissance de l'intensité du faisceau réfléchi.

Fig. 1a

Fig. 1b

Fig. 2

Fig. 3

Fig. 4

Fig. 5

Fig. 6

Europäisches
Patentamt

European
Patent Office

Office européen
des brevets

**RAPPORT DE RECHERCHE EUROPEENNE**

Numéro de la demande

EP 19 20 0155

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | Kim, Jang, Kim, Cho, Kang, Lee: "Growth characterization of carbon nanotubes by using optical interference oscillations phenomena", , vol. 41, no. 5 30 novembre 2002 (2002-11-30), pages L587-L590, XP002792909, Extrait de l'Internet: URL:http://citenpl.internal.epo.org/wf/web/citenpl/citenpl.html [extrait le 2019-07-12] * abrégé * * alinéa [Introduction] * * figures 1-3 * ----- | 1-14 | INV. C01B32/158 C01B32/16 |
| Y | GEOHEGAN D B ET AL: "In situ growth rate measurements and length control during chemical vapor deposition of vertically aligned multiwall carbon nanotubes", APPLIED PHYSICS LETTERS, A I P PUBLISHING LLC, US, vol. 83, no. 9, 1 septembre 2003 (2003-09-01), pages 1851-1853, XP012035972, ISSN: 0003-6951, DOI: 10.1063/1.1605793 * abrégé * * figures 1,2 * * page 1851 - page 1852 * ----- -/-- | 1-14 | DOMAINES TECHNIQUES RECHERCHES (IPC) C01B |

Le présent rapport a été établi pour toutes les revendications

| Lieu de la recherche | Date d'achèvement de la recherche | Examinateur |
|---|---|---|
| La Haye | 21 février 2020 | Mertins, Frédéric |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
................................................................
& : membre de la même famille, document correspondant

EPO FORM 1503 03.82 (P04C02)

page 1 de 2

Europäisches
Patentamt

European
Patent Office

Office européen
des brevets

# RAPPORT DE RECHERCHE EUROPEENNE

Numéro de la demande

EP 19 20 0155

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | KIM D-H ET AL: "In situ monitoring of carbon nanotube growth", CAR, ELSEVIER, OXFORD, GB, vol. 41, no. 3, 1 janvier 2003 (2003-01-01), pages 583-585, XP004408937, ISSN: 0008-6223, DOI: 10.1016/S0008-6223(02)00350-0 * abrégé * * figures 1,2 * | 1-14 | |
| Y | JÖNSSON M ET AL: "In situ growth rate measurements during plasma-enhanced chemical vapour deposition of vertically aligned multiwall carbon nanotube films", NANOTECHNOLOGY, IOP, BRISTOL, GB, vol. 18, no. 30, 1 août 2007 (2007-08-01), page 305702, XP020119411, ISSN: 0957-4484, DOI: 10.1088/0957-4484/18/30/305702 * abrégé * * alinéas [experimentalset] - [00up] * * page 3 * * figures 1,3,4 * | 1-14 | |
| Y | NG H T ET AL: "Growth of carbon nanotubes: a combinatorial method to study the effects of catalysts and underlayers", JOURNAL OF PHYSICAL CHEMISTRY. B, MATERIALS, SURFACES, INTERFACES AND BIOPHYSICAL, WASHINGTON, DC, US, vol. 107, no. 33, 21 août 2003 (2003-08-21), pages 8484-8489, XP002450951, ISSN: 1089-5647 * abrégé * * figures 1,4 * | 1-14 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| La Haye | 21 février 2020 | Mertins, Frédéric |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 03.82 (P04C02)

page 2 de 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014191915 A

**Littérature non-brevet citée dans la description**

- **C. RYAN OLIVER et al.** Statistical analysis of variation in laboratory growth of carbon nanotubes forests and recommendations for improved consistency. *ACS NANO,* 2013, vol. 7 (4), 3565-3580
- **A. A. PURETZKY et al.** real-time imaging of vertically aligned carbon nanotube array growth kinetics. *Nanotechnology,* 2008, vol. 19, 05560
- **E.R. MESHOT ; A.J. HART.** Abrupt self-termination of vertically aligned carbon nanotube growth. *Applied Physics Letters,* 2008, vol. 92, 113107

- **Y. HAYASHI et al.** Analysis of early stages of vertically aligned carbon nanotube growth by plasma-enhanced chemical vapor deposition. *Japanese Journal of Applied Physics,* 2005, vol. 44 (4A), 1549-1553
- **D.B. GEOGHEGAN et al.** In situ growth rate measurements and length control during chemical vapor deposition of vertically aligned multiwall carbon nanotubes. *Applied Physics Letters,* 2003, vol. 83 (9), 1851-1853